# FASCICULE DE BREVET EUROPEEN

(11) **EP 2 878 002 B1**
(45) Date de publication et mention de la délivrance du brevet: **03.01.2018**
(21) Numéro de dépôt: 13747985.3
(22) Date de dépôt: 12.07.2013
(51) Int. Cl.: H01G 4/30, H01G 4/33, H01L 49/02, H01G 4/38, H05K 1/18

(54) **PROCÉDÉ POUR LA RÉALISATION D'UNE CAPACITÉ**
HERSTELLUNGSVERFAHREN FÜR EIN KONDENSATOR
METHOD FOR PRODUCING A CAPACITOR

(30) Priorité: 25.07.2012 FR 1257227
(43) Date de publication de la demande: 03.06.2015
(73) Titulaire: Commissariat à l'Énergie Atomique et aux Énergies Alternatives, 75015 Paris (FR); STMicroelectronics S.A., 92120 Montrouge (FR)
(72) Inventeur: LAMY, Yann, F-38960 Saint Etienne de Crossey (FR); GUILLER, Olivier, F-38000 Grenoble (FR); JOBLOT, Sylvain, F-38690 Bizonnes (FR)
(74) Mandataire: Decobert, Jean-Pascal
(86) Numéro de dépôt international: PCT/EP2013/064863
(87) Numéro de publication internationale: WO 2014/016147

(56) Documents cités:
- EP-A1- 1 953 778
- JP-A- 2008 251 878
- US-A1- 2009 090 998
- US-A1- 2011 084 360
- US-A1- 2012 061 798

## Description

### DOMAINE TECHNIQUE DE L'INVENTION

La présente invention concerne l'intégration de capacités tridimensionnelles (aussi dénommées capacités 3D) réalisée dans des cavités gravées à l'intérieur d'un substrat tout en conservant une capacité planaire en surface.

### ETAT DE LA TECHNIQUE

Les capacités 3D, par exemple les capacités MIM (Métal/Isolant/Métal), sont largement utilisées dans les circuits intégrés. L'intérêt technologique des capacités 3D réside dans le fait que les capacités sont empilables et comportent une surface développée dans le plan (x ;y) du substrat mais également sur la hauteur/épaisseur z, permettant un gain de place important et une surface développée de la capacité plus grande qu'une capacité planaire. Par exemple, une capacité MIM peut se trouver en superposition avec des composants actifs.

La publication de M. Thomas et al. (IEEE 2007) intitulée «Impact of TaN/Ta copper barrier on full PEALD TiN/Ta205/TiN 3D damascene - MIM capacitor performance» (M. Thomas, A. Farcy, E. Deloffre, M. Gros-Jean, C. Perrot, D. Benoit, C. Richard, P. Caubet, S. Guillaumet, R. Pantel, B. Chenevier, J. Torres, Proceedings of the IEEE 2007 International Interconnect Technology Conférence - Digest of Technical Papers, art. no. 4263689, pp. 158-160) propose une réalisation de l'intégration de capacités 3D, particulièrement de capacités MIM, au niveau de fin de ligne d'interconnexions, généralement dénommée en anglais « back-end-of-line » (BEOL) d'une plaquette autrement dénommée en anglais « wafer ». Un dépôt de quatre couches de matériaux, respectivement isolant, métallique, isolant et métallique, est réalisé sur la surface d'un substrat, et également sur la paroi de tranchées de petites dimensions gravées dans le substrat.

Les tranchées sont ensuite remplies par un métal conducteur. Ensuite, afin de ne laisser l'empilement de trois couches MIM que dans les tranchées, une planarisation, par exemple, un polissage CMP, acronyme de l'anglais « Chemical-mechanical planarization », est réalisée pour enlever l'empilement MIM au niveau de la surface du substrat. Cependant ce procédé aboutit à une perte sur la capacité totale due au polissage CMP. En effet, seul l'empilement MIM dans les tranchées participe à la capacité du dispositif, la capacité en surface du substrat étant perdue. Le document US2009/090998A1 divulgue des condensateurs MIM formés dans un substrat dans lequel on forme une tranchée et un caisson. Le document EP1953778A1 divulgue des circuits intégrés et autres circuits monolithiques, et plus particulièrement la formation d'un condensateur dans de tels circuits. Le document D3 US20011084360A1 divulgue des condensateurs de type condensateur en tranchée pour composant semi conducteurs. Les documents US2012061798A1 et JP2008251878A divulguent des condensateurs tranchées doubles pour composant électronique semi conducteur. Le brevet américain US 8,085,524-B2 propose un autre procédé pour réaliser une capacité MIM intégrée dans un substrat silicium qui sert lui-même d'électrode. Des tranchées sont gravées dans le substrat. Un empilement capacitif (MIM ou MIMIM) est ensuite déposé sur la paroi des tranchées. Les couches de l'empilement capacitif sont ensuite gravées une à une, ce qui rend le procédé lourd, car pour chaque couche une lithographie et une gravure doivent être réalisées. Le procédé est donc long et coûteux.

De plus, les nouveaux matériaux, tels qu'un matériau à constante diélectrique élevée du type connu sous le vocable « high-k », déposés dans l'empilement capacitif se gravent très difficilement, ce qui complique fortement le procédé de réalisation de capacités les employant.

### RESUME DE L'INVENTION

La présente invention permet de remédier en tout ou partie aux inconvénients des techniques actuellement connues.

En particulier, un aspect de l'invention est relatif à un procédé pour la réalisation d'une capacité comprenant une formation d'un empilement capacitif dans une portion d'un substrat. Le procédé comporte la formation d'une cavité suivant l'épaisseur de la portion du substrat à partir d'une face supérieure dudit substrat, le dépôt d'une pluralité de couches participant à l'empilement capacitif sur la paroi de la cavité et sur la surface de la face supérieure, et un enlèvement de la matière des couches jusqu'à la surface de la face supérieure.

Ce procédé est caractérisé en ce que la formation de ladite cavité comporte la formation d'au moins une tranchée et, associé à chaque tranchée, d'au moins un caisson. Ladite au moins une tranchée comporte une embouchure de tranchée débouchant dans le caisson, et ledit caisson comporte une embouchure de caisson débouchant au niveau de la surface de la face supérieure. L'embouchure de caisson est formée plus grande que l'embouchure de tranchée.

On réalise ainsi une capacité totale plus importante et avec une dimension non purement verticale (c'est-à-dire pas seulement orientée selon l'épaisseur du substrat). Ce faisant, on préserve la possibilité d'un enlèvement superficiel des couches, optimisé par polissage CMP par exemple. Avantageusement, l'élargissement produit par le caisson, au niveau de la surface du substrat, peut faciliter les connexions des éléments capacitifs vers des composants extérieurs ou vers d'autres capacités.

Un autre aspect de la présente invention concerne un dispositif microélectronique comportant un substrat dans une portion duquel s'étend une cavité suivant l'épaisseur du substrat depuis une face supérieure du substrat. Le dispositif comporte un empilement capacitif constituant au moins en partie une capacité et comportant une pluralité de couches sur la paroi de la cavité et sur la surface de la face supérieure.

Le dispositif microélectronique est caractérisé en ce que la cavité comporte au moins une tranchée et associée à chaque tranchée au moins un caisson, ladite au moins une tranchée comportant une embouchure de tranchée débouchant dans le caisson, ledit caisson comportant une embouchure de caisson débouchant au niveau de la surface de la face supérieure, l'embouchure de caisson étant plus grande que l'embouchure de tranchée.

D'autres aspects de modes de réalisation de l'invention sont aussi relatifs à un procédé dans lequel la formation du caisson comprend la formation d'une paroi de fond du caisson située dans le plan de l'embouchure de tranchée et de section plus grande que celle de l'embouchure de tranchée.

### BREVE DESCRIPTION DES FIGURES

L'invention serait bien comprise au vu des planches de dessins qu'elle intègre et qui présentent des modes de réalisation avantageux mais non limitatifs de l'invention.
La figure 1 résume les principales étapes de fabrication d'une capacité selon un premier mode de réalisation du procédé de l'invention.
Les figures 2a à 2g décrivent des étapes du premier mode de réalisation selon le procédé de l'invention.
La figure 3 illustre la structure d'une capacité MIM selon un deuxième mode de réalisation de la présente invention.
La figure 4 montre une vue de dessus de la capacité avec deux types de tranchées différentes : trous de section circulaire (gauche) et fentes de section rectangulaires (droite).
La figure 5 illustre la structure d'une capacité Métal-Isolant-Semi-conducteur MIS d'un troisième mode de réalisation selon la présente invention.
La figure 6 illustre la structure d'une capacité avec un dépôt non conforme selon un quatrième mode de réalisation de la présente invention.
La figure 7 illustre la structure d'une capacité MIMIM non conforme d'un cinquième mode de réalisation selon la présente invention.
La figure 8 présente un autre mode de réalisation de l'invention avec une structure différente de caisson.
La figure 9 montre une variante de la figure 8.
La figure 10 montre le mode de réalisation avec la structure du caisson illustré en figure 8 à l'issue de la formation de contacts d'électrode.
La figure 11 montre le mode de réalisation avec la structure du caisson illustré en figure 9 à l'issue de la formation de contacts d'électrode.

### DESCRIPTION DETAILLEE

Il est précisé que dans le cadre de la présente invention, les termes « sur » ou « au-dessus » ne signifient pas obligatoirement « au contact de ». Ainsi par exemple, le dépôt d'une pluralité de couches au-dessus d'une paroi d'une cavité ne signifie pas obligatoirement que la pluralité de couches et ladite paroi sont directement au contact l'une de l'autre, mais cela signifie que la pluralité de couches recouvre au moins partiellement la paroi en étant, soit directement à son contact, soit en étant séparée d'elle par une autre couche ou un autre élément.

Le terme « supérieur » employé en particulier pour qualifier une face du substrat ne sert ici qu'à désigner une première des deux faces du substrat (l'autre étant la face inférieure), sans pour autant faire de quelconque hypothèse sur la position relative des faces, suivant une direction verticale. La face supérieure aurait pu ainsi être aussi nommée face avant, en opposition à une face arrière.

Les formes ou dimensions données pour certains composants de la présente invention ne sont toujours qu'indicatives et s'entendent comme incluant des formes et dimensions sensiblement équivalentes.

Avant d'entamer une revue détaillée de modes de réalisation de l'invention, sont énoncées ci-après des caractéristiques optionnelles qui peuvent éventuellement être utilisées en association ou alternativement :
- La formation du caisson comprend la formation d'une paroi de fond du caisson située dans le plan de l'embouchure de tranchée et de section plus grande que celle de l'embouchure de tranchée.
- Le caisson est formé de manière parallélépipédique rectangle, ou encore cylindrique, avec une section circulaire notamment, ces formes n'étant pas limitatives. D'autres formes peuvent également être utilisées comme par exemple des formes polygonales.
- La au moins une tranchée est formée avec une section circulaire transversalement à l'épaisseur du substrat.
- La au moins une tranchée est formée avec une section rectangulaire ou carrée transversalement à l'épaisseur du substrat.
- Le caisson est formé avec un rapport de forme inférieur à 1 entre sa dimension suivant l'épaisseur de la portion du substrat et sa dimension transversale à ladite épaisseur et dans lequel la au moins une tranchée est formée avec un rapport de forme supérieur à 1 entre sa dimension suivant l'épaisseur de la portion du substrat et sa dimension transversale à ladite épaisseur.
- Ladite pluralité de couches comporte successivement au-dessus de la paroi de la cavité, une première couche de matériau conducteur configurée pour former au moins en partie une électrode inférieure de la capacité, une deuxième couche de matériau isolant et une deuxième couche de matériau conducteur qui forme au moins en partie une électrode supérieure de la capacité.
- Une gravure partielle d'une couche de matériau conducteur est configurée pour que la couche de matériau conducteur s'arrête à un niveau inférieur à celui de la deuxième couche de matériau isolant suivant l'épaisseur du substrat.
- Ladite pluralité de couches comporte une couche de matériau isolant située au-dessus de la paroi de la cavité et au-dessous de la première couche de matériau conducteur.
- L'utilisation de la portion du substrat comme électrode inférieure de la capacité et dans lequel le dépôt de ladite pluralité de couches comporte successivement au-dessus de la paroi de la cavité, le dépôt d'une couche de matériau isolant et d'une couche de matériau conducteur qui forme au moins en partie une électrode supérieure de la capacité.
- Une gravure partielle d'une couche de matériau conducteur est configurée pour que la couche de matériau conducteur s'arrête à un niveau inférieur à celui de la deuxième couche isolante suivant l'épaisseur du substrat.
- La formation d'au moins un empilement capacitif additionnel par dépôts successifs, au-dessus de la couche de matériau conducteur configurée pour former au moins en partie une électrode supérieure de la capacité, d'une couche additionnelle de matériau isolant et d'une couche additionnelle de matériau conducteur. De manière avantageuse, les empilements additionnels se trouvent emboités les uns dans les autres.
- La formation du caisson comprend la formation d'une paroi de flanc de caisson s'évasant en direction de l'embouchure de caisson. Notamment, la paroi de flanc a une forme évasée dans au moins une portion de la hauteur du caisson depuis un niveau de hauteur situé plus vers l'embouchure de tranchée vers un niveau de hauteur située plus vers l'embouchure de caisson. On forme ainsi notamment un élargissement latéral tout en progressant vers l'embouchure de caisson.
- La formation d'une paroi de flanc de caisson s'évasant comprend la formation, sur la paroi de flanc de caisson s'évasant, d'au moins un palier à un niveau intermédiaire entre l'embouchure de tranchée et l'embouchure de caisson suivant l'épaisseur de la portion de substrat, le au moins un palier étant configuré pour définir deux étages de caisson.
- Les dépôts successifs du au moins un empilement capacitif additionnel sont configurés pour préserver un espace résiduel délimité par ledit empilement additionnel.
- On forme autant d'étages de caisson que d'empilements capacitifs.
- Selon un mode de réalisation, on forme un premier empilement capacitif additionnel au-dessus de la couche de matériau conducteur configurée pour former au moins en partie une électrode supérieure de la capacité, et dans lequel la profondeur de l'étage situé directement sous l'embouchure de caisson suivant l'épaisseur de la portion de substrat est choisie : supérieure à la somme des épaisseurs de l'électrode inférieure de la capacité et de la deuxième couche de matériau isolant ; inférieure ou égale à l'épaisseur de l'empilement capacitif ;
   et dans lequel la profondeur de l'étage situé directement en dessous de l'étage situé directement sous l'embouchure de caisson suivant l'épaisseur de la portion de substrat est choisie : supérieure à la somme des épaisseurs de l'électrode supérieure de la capacité et de la couche additionnelle de matériau isolant du premier empilement capacitif additionnel; inférieure ou égale à la somme des épaisseurs dudit premier empilement capacitif additionnel et de l'électrode supérieure de la capacité.
- Selon un autre mode de réalisation, on forme un premier empilement capacitif additionnel au-dessus de la couche de matériau conducteur configurée pour former au moins en partie une électrode supérieure de la capacité, et dans lequel la profondeur de l'étage situé directement sous l'embouchure de caisson suivant l'épaisseur de la portion de substrat est choisie : supérieure à la somme des épaisseurs de l'électrode supérieure de la capacité et de la couche additionnelle de matériau isolant du premier empilement capacitif additionnel; inférieure ou égale à la somme des épaisseurs dudit premier empilement capacitif additionnel et de l'électrode supérieure de la capacité : et dans lequel la profondeur de l'étage situé directement en dessous de l'étage situé directement sous l'embouchure de caisson suivant l'épaisseur de la portion de substrat est choisie : supérieure à la somme des épaisseurs de l'électrode inférieure de la capacité et de la deuxième couche de matériau isolant ; inférieure ou égale à l'épaisseur de l'empilement capacitif.
- Pour tout deuxième empilement capacitif additionnel formé au-dessus du premier empilement capacitif additionnel, on forme un étage supplémentaire situé à un niveau de profondeur supérieur relativement à l'étage correspondant à un empilement capacitif précédent, la profondeur de l'étage supplémentaire est choisie :
   - supérieure à la somme des épaisseurs de la couche additionnelle de matériau conducteur de l'empilement capacitif additionnel précédent et de la couche additionnelle de matériau isolant dudit deuxième empilement capacitif additionnel;
   - inférieure ou égale à la somme des épaisseurs dudit deuxième empilement capacitif additionnel et de la couche additionnelle de matériau conducteur dudit empilement capacitif additionnel précédent.
- On connecte électriquement la première couche de matériau conducteur et la couche additionnelle de matériau conducteur d'au moins un empilement capacitif additionnel de sorte à former l'électrode inférieure.
- On raccorde électriquement le substrat et la couche additionnelle de matériau conducteur d'au moins un empilement capacitif additionnel de sorte à former l'électrode inférieure.
- Le dépôt de la pluralité de couches comprend le dépôt non conforme d'au moins une couche.
- Le dépôt non conforme est configuré pour que l'épaisseur de dépôt de ladite au moins une couche soit plus grande dans le caisson suivant une direction transversale à l'épaisseur du substrat que celle de dépôt de ladite au moins une couche dans la tranchée.
- Depuis la face supérieure, un dépôt d'un matériau de remplissage d'un espace résiduel de la cavité est réalisé après ledit dépôt de la pluralité de couches ; puis un enlèvement du matériau de remplissage et de la pluralité de couches sur la surface de la face supérieure.
- Le matériau de remplissage peut-être aussi bien conducteur (par exemple un métal ou un polymère conducteur) qu'isolant (par exemple un polymère isolant).
- Ladite réalisation dudit enlèvement comprend une planarisation par polissage mécano-chimique ou mécanique CMP.
- La portion du substrat est formée pour partie avec une couche superficielle de substrat déposée sur une couche inférieure du substrat avant la formation de ladite cavité, et dans lequel la profondeur du caisson suivant l'épaisseur du substrat est inférieure à l'épaisseur de ladite couche superficielle.
- Des matériaux conducteurs utilisables pour former au moins une électrode peuvent être métalliques et par exemple du Cu ou TiN ou TaN ou être un polymère conducteur ou encore un semi-conducteur préférentiellement dopé par exemple du polysilicium dopé n.
- L'épaisseur d'au moins une couche d'au moins un des empilements capacitifs est inférieure à 100nm.

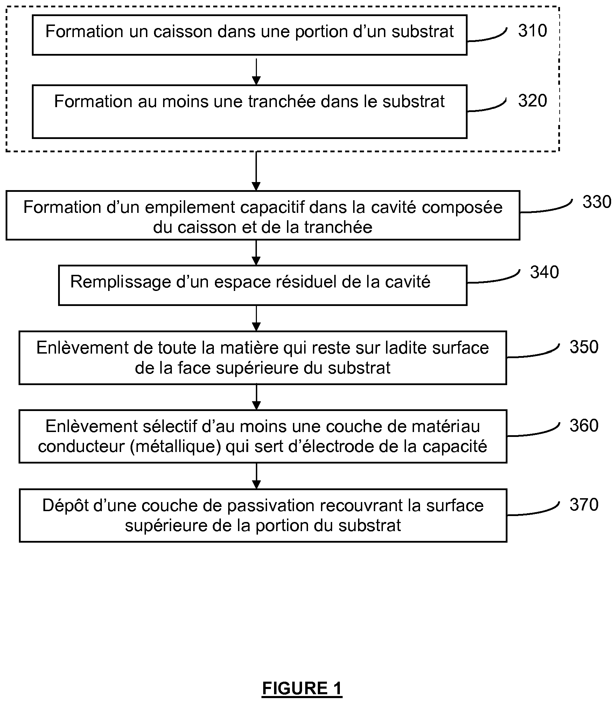

La figure 1 résume les principales étapes de fabrication d'une capacité 200 selon un premier mode de réalisation du procédé de l'invention. Des étapes 310, 320, 330, 340, 350, 360 et 370 y sont représentées de manière synthétique. Elles sont détaillées ci-après en référence aux autres figures.

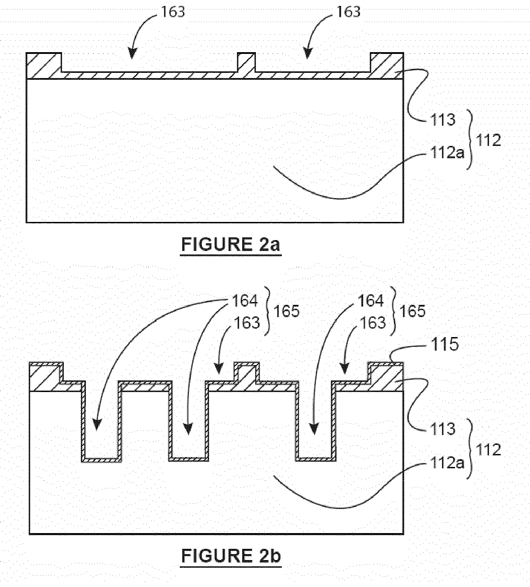

Les figures 2a à 2g décrivent des étapes du premier mode de réalisation selon le procédé de l'invention. La capacité 200 peut être réalisée dans tout type de substrat, préférentiellement le silicium.

La figure 2a illustre la structure de formation de capacité à l'issue de l'étape 310. L'étape 310 consiste à former un caisson 163 par une gravure dans une portion d'un substrat 112. Le but de la formation du caisson 163, qui n'a pas besoin d'être très profond, est de conserver intact un empilement capacitif réalisé ultérieurement.

Selon ce mode de réalisation, avant de former le caisson 163, une couche superficielle de substrat 113, par exemple l'oxyde de silicium, est déposée sur une couche inférieure 112a du substrat 112. Un des buts du dépôt de la couche superficielle de substrat 113 est de définir une partie de substrat dans laquelle va s'étendre en profondeur le caisson 163 qui présente ainsi préférentiellement une profondeur inférieure à l'épaisseur de la couche superficielle 113. La profondeur du caisson 163 est par exemple, entre 0.5 et 1µm (micromètre).

Le caisson 163 comporte une embouchure de caisson qui débouche au niveau de la surface supérieure du substrat 112. Le caisson 163 est par exemple formé de manière parallélépipédique rectangle.

Il convient de noter que le dépôt de la couche superficielle de substrat 113 n'est pas une étape indispensable ; autrement dit, le caisson 163 peut très bien être gravé directement dans la couche inférieure 112a du substrat 112.

La figure 2b illustre la structure de formation de capacité à l'issue de l'étape 320. L'étape 320 consiste à former au moins une tranchée 164 par une gravure dans la portion du substrat 112 en formant une embouchure de tranchée qui débouche dans le caisson 163. Selon ce mode de réalisation, la au moins une tranchée 164 est formée, soit avec une section rectangulaire, soit avec une section circulaire, transversalement à l'épaisseur du substrat 112. La profondeur de la au moins une tranchée 164 est de préférence entre 30 et 200 µm. De plus, afin de garantir une surface développée la plus grande possible pour augmenter la valeur de la capacité 200, au moins une tranchée 164 est de rapport de forme élevée, c'est-à-dire l'aspect ratio est supérieur à 2.

Le but des étapes 310 et 320 est de former une cavité 165 pour conserver un empilement capacitif ultérieurement. La structure de la cavité 165 permet d'optimiser au mieux les surfaces verticales et horizontales de la capacité 200 développées dans la cavité 165 et en surface de la portion du substrat 112. En outre, la réalisation des étapes 310 et 320 peut être inversée. L'ensemble du caisson 163 et de la au moins une tranchée 164 constitue la cavité 165 suivant l'épaisseur de la portion du substrat 112 à partir d'une face supérieure dudit substrat 112.

L'embouchure de caisson est formée plus grande que l'embouchure de tranchée. De plus, la paroi de fond du caisson 163, située dans le plan de ladite embouchure de tranchée, est plus grande que celle de l'embouchure de tranchée.

Préférentiellement, le caisson 163 est formé avec un rapport de forme inférieur à 1 entre sa dimension suivant l'épaisseur de la portion du substrat 112 et sa dimension transversale à ladite épaisseur et la au moins une tranchée 164 est formée avec un rapport de forme supérieur à 1 entre sa dimension suivant l'épaisseur de la portion du substrat 112 et sa dimension transversale à ladite épaisseur.

En outre, une couche de matériau isolant 115 peut être réalisée sur la paroi de la cavité 165 et la surface supérieure du substrat 112 à ce stade, notamment par une passivation et par exemple par dépôt. Le matériau de la couche de matériau isolant 115 est par exemple du SiO₂.

Il convient de noter que cette réalisation de la couche de matériau isolant 115 ne fait pas partie des processus indispensables de ce procédé. Elle peut être considérée, dans certains modes de réalisation, comme une couche d'un empilement capacitif dont la majeure partie est réalisée ultérieurement, dans l'étape suivante 330.

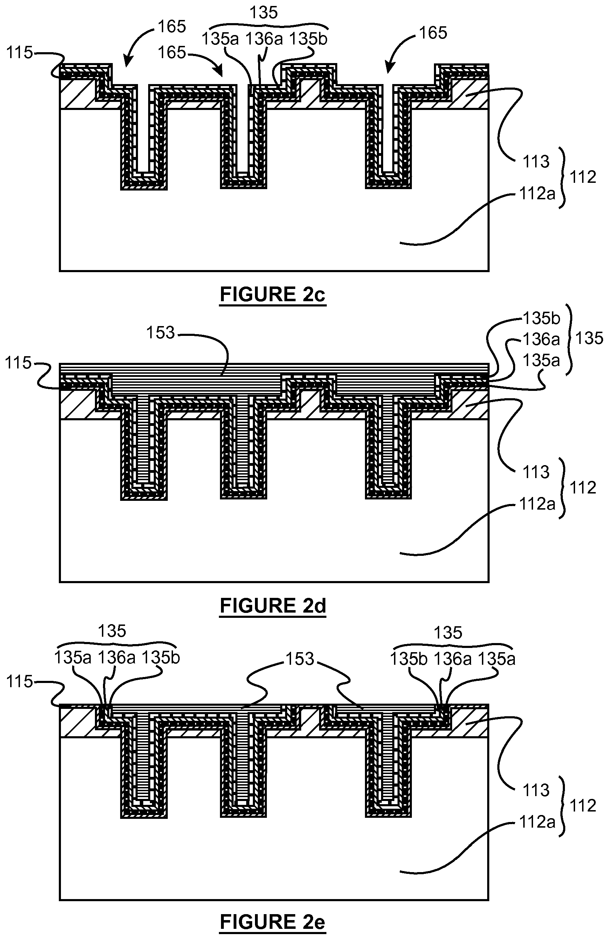

La figure 2c illustre la structure de formation de capacité à l'issue de l'étape 330. L'étape 330 consiste à déposer une pluralité de couches participant à l'empilement capacitif mentionné ci-dessus sur la paroi (à savoir sur les bords (c'est-à dire les flancs) et sur le fond) de la cavité 165 et la surface supérieure du substrat 112. Au moins une couche de l'empilement capacitif sert d'électrode de la capacité 200.

Selon ce mode de réalisation, l'empilement capacitif est un empilement MIM 135 comportant trois couches successivement disposées au-dessus de la paroi de la cavité 165 : une première couche de matériau conducteur et notamment métallique 135a qui forme au moins en partie une électrode inférieure de la capacité 200, une deuxième couche de matériau isolant 136a et une deuxième couche de matériau conducteur et notamment métallique 135b qui forme au moins en partie une électrode supérieure de la capacité 200.

L'empilement MIM 135 peut être déposé de manière conforme avec, par exemple, une technique de dépôt pleine plaque telle que l'ALD acronyme de l'anglais « Atomic Layer Deposition ». Ainsi, l'ensemble de la cavité 165 est bien recouverte par l'empilement MIM 135. Le choix des matériaux des deux couches métalliques 135a et 135b est large, par exemple, TiN, TaN, Ru, Cu, TiW, etc. Ces deux couches peuvent également être composées d'un empilement de plusieurs matériaux. Pour la couche de matériau isolant 136a, on choisira un isolant avec une bonne constante diélectrique et une bonne tenue au claquage, comme par exemple Al2O3, ZrO2, HfO2, Ta2O5. Une combinaison de diélectrique peut également être réalisée pour améliorer les propriétés de l'isolant.

Il convient de noter que dans d'autres modes de réalisation, la couche 115, située au-dessus de la paroi de la cavité 165 et au-dessous de la première couche de matériau métallique 135a, peut être considérée comme une couche de l'empilement capacitif et réalisée à ce stade.

La figure 2d illustre la structure de formation de capacité à l'issue de l'étape 340. L'étape 340 est une étape facultative qui consiste à remplir un espace résiduel de la cavité 165 depuis la face supérieure du substrat 112 par un matériau de remplissage 153. Plus précisément, afin d'assurer une meilleure conduction de l'électrode supérieure de la capacité 200, la au moins une tranchée 164 et avantageusement aussi le caisson 163 peuvent être remplis complètement ou partiellement en électrolyse (déposition électrochimique) ECD, par le matériau de remplissage 153 qui est par exemple un métal conducteur tel que le cuivre ou tungstène ou encore polysilicium. Le matériau de remplissage 153 peut-être aussi bien conducteur (par exemple un métal ou un polymère conducteur) qu'isolant (par exemple un polymère isolant).

La couche 135b désignée pour former l'électrode supérieure de la capacité 200 peut servir de fond continu pour générer le matériau de remplissage 153.

Ensuite, la figure 2e illustre la structure de formation de capacité à l'issue de l'étape 350. L'étape 350 consiste à réaliser un enlèvement de toute la matière qui reste sur la surface de la face supérieure du substrat 112. Selon le présent mode de réalisation, ladite matière comportant la matière de l'empilement MIM 135 et le matériau de remplissage 153 est enlevée par une méthode de planarisation, telle qu'un polissage mécano-chimique ou mécanique CMP, acronyme de l'anglais « Chemical Mechanical Polishing ».

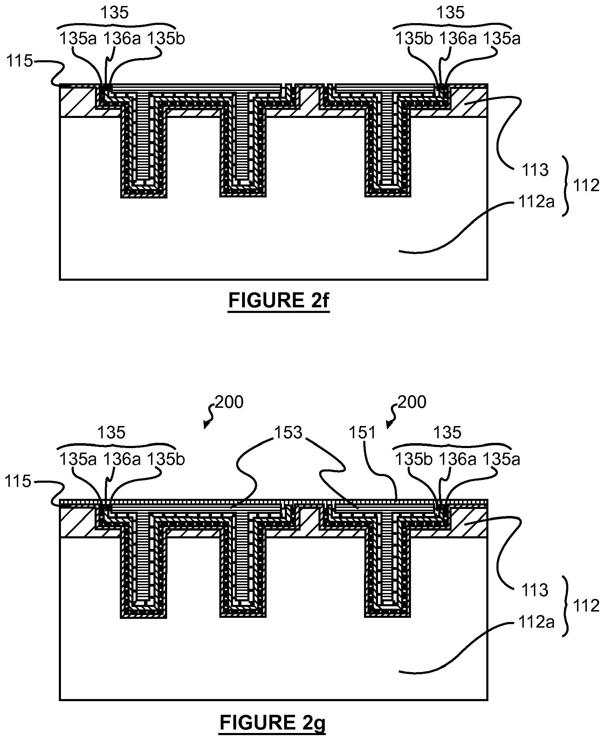

La figure 2f illustre la structure de formation de capacité à l'issue de l'étape 360. L'étape 360 consiste à réaliser un enlèvement sélectif d'au moins une couche de matériau métallique qui sert d'électrode de la capacité 200. Plus précisément, selon le présent mode de réalisation, les deux couches de matériau métallique 135a et 135b sont gravées depuis ladite surface supérieure pour que les deux couches de matériau métallique 135a et 135b s'arrêtent à un niveau inférieur à celui de la couche de matériau isolant 136a suivant l'épaisseur de la portion du substrat 112.

Cette étape est réaliser afin d'éviter les courts-circuits possibles entre les électrodes après la dernière étape 350. Il s'agit d'une gravure métal pour éliminer les débris, filaments, etc, qui pourraient être encore présents sur ladite surface supérieure.

La figure 2g illustre la structure de formation de capacité à l'issue de l'étape 370. L'étape 370 consiste à déposer une couche de passivation 151 recouvrant la surface supérieure de la portion du substrat 112 et contactant les extrémités des couches 135a, 136a et 135b. Le matériau de la couche de passivation 151 est par exemple un matériau diélectrique tel que le SiN ou le SiO₂. A ce stade, le procédé peut soit continuer en face supérieure par des niveaux supplémentaires de métaux sur la surface de la couche de passivation 151, soit continuer en face arrière (celle opposée à la face supérieure du substrat 112) après amincissement pour venir contacter l'électrode inférieure de la capacité 200.

La figure 2g illustre la structure de la capacité 200 après la réalisation de toutes les étapes selon le premier mode de réalisation de la présente invention.

L'empilement 115, 135a, 136a, 135b épouse la forme de la cavité, à savoir la forme de la tranchée et la forme du caisson : on augmente ainsi artificiellement la longueur de l'empilement capacitif et donc la capacité et facilite la reprise de contact de chaque électrode.

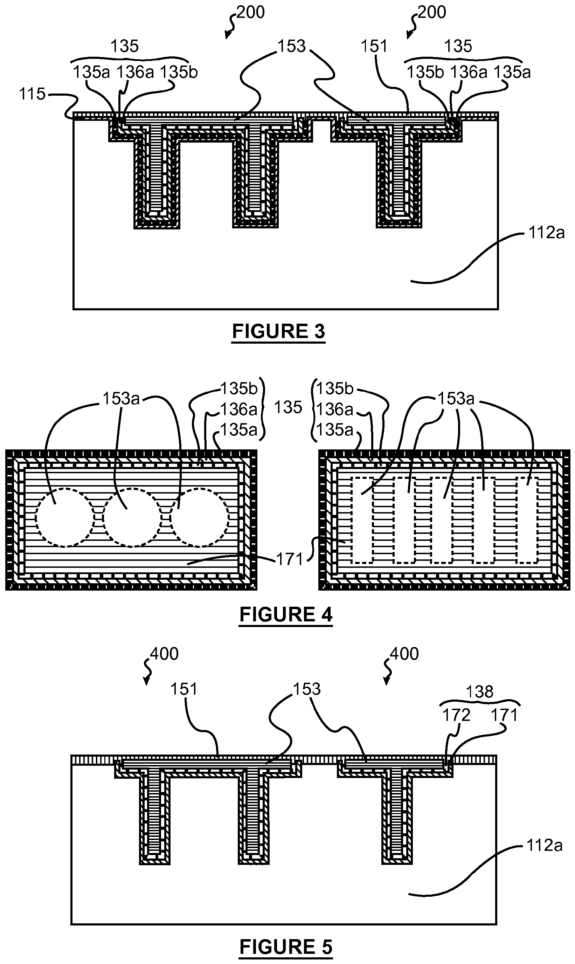

La figure 3 illustre une autre structure de capacité sans la couche superficielle de substrat 113, comme mentionné dans la description concernant l'étape 310, selon un deuxième mode de réalisation.

Un avantage est que l'empilement MIM 135 en surface ne sera enlevé que dans la zone extérieure au caisson 163 qui définit donc précisément le contour de la capacité 200. Autrement dit, la partie 171 de l'empilement MIM 135 située dans la zone extérieure au caisson 163 est la capacité planaire récupérée. Ceci est illustré par la figure 4 qui montre une vue de dessus de la capacité 200. Deux types de tranchées 164 sont représentés dans la figure 4 : trous de section circulaire (gauche) et fentes de section rectangulaire (droite). Le nombre de tranchées n'est pas limité.

Le gain de capacité correspondant à la surface planaire de la capacité 200 préservée par le caisson 163 aisément compris entre 7% et 18%.

On s'aperçoit que le gain de capacité est significatif, environ 18%, dans le cas d'un design standard (trou rond de 6µm, espacés de 10µm). Dans le cas d'un design très agressif (trou rond de 6µm, espacés de 5µm), la capacité planaire récupérée est de 7% car la contribution de la paroi verticale de la cavité 165 est plus importante. Ceci est d'autant plus accentué quand la cavité 165 est profonde. Un gain moyen minimum de capacité peut être estimé à environ 10% pour une profondeur typique de cavité 165 de l'ordre de 80µm. De plus, le procédé permet l'utilisation d'un large choix de matériaux, même les plus avancés comme les diélectriques high-k, sans se soucier de leur gravure grâce au polissage CMP.

La figure 5 illustre la structure d'une capacité 400 d'un troisième mode de réalisation selon la présente invention. La présente invention est également adaptée au cas où un substrat 112 sert également d'électrode inférieure de la capacité 400. La capacité 400 est alors une capacité MIS (Métal - Isolant - Semi-conducteur). Dans ce cas, le silicium du substrat 112 doit être dopé pour assurer une bonne conduction.

Lors des étapes 310 et 320 pour former une cavité 165, un caisson 163 et au moins une tranchée 164 sont gravés directement dans le substrat 112. Après la réalisation des étapes 330 à 370, un empilement capacitif 138 est déposé en surface du substrat 112 et sur la paroi de la cavité 165. L'empilement capacitif 138 comporte, successivement au-dessus de la paroi de la cavité 165, une couche de matériau métallique 171 qui sert d'électrode supérieure de la capacité 400 et une couche 172, par exemple de matériau isolant.

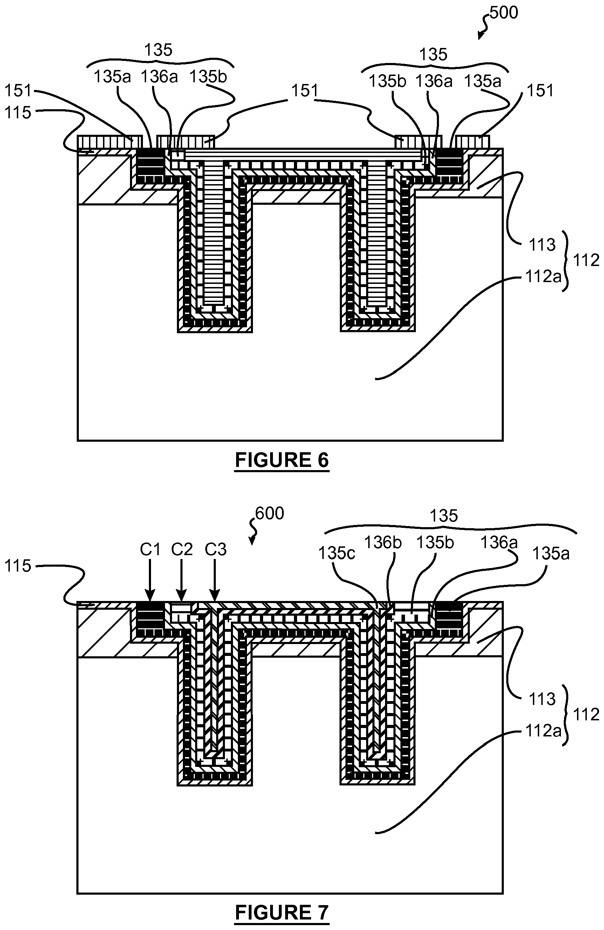

La présente invention permet également un dépôt non conforme d'au moins une couche participant à la formation d'un empilement capacitif. Une capacité 500 formée par un dépôt non conforme est illustrée sur la figure 6.

La seule différence entre la capacité 200 du premier mode de réalisation et la capacité 500 de ce quatrième mode de réalisation, est la taille de l'épaisseur E1 de la couche de matériau métallique 135a suivant une direction transversale dans le caisson 163. Dans la capacité 200, l'épaisseur E1 est égale à l'épaisseur E2 de la couche de matériau métallique 135a dans au moins une tranchée 164. En revanche, dans la capacité 500, l'épaisseur E1 est plus grande que l'épaisseur E2 dans la au moins une tranchée 164. Ceci permet de contacter l'empilement MIM 135 par la face avant uniquement.

Le dépôt non conforme de la couche de matériau métallique 135a, à l'étape 330 selon le procédé, peut également être composé des deux étapes suivantes:
- un dépôt conforme pour atteindre le fond d'une tranchée 164; puis
- un dépôt non conforme épais pour élargir la surface de connexion en surface du substrat 112.

De plus, en répétant l'étape 330, cela permet un empilement capacitif composé d'une pluralité de capacités dans la cavité 165. Cela augmente d'autant la capacité intégrée. La figure 7 illustre la structure d'une capacité 600 d'un cinquième mode de réalisation selon la présente invention.

Selon ce mode de réalisation, après le dépôt d'un empilement capacitif composé des couches 135a, 136a et 135b, l'étape 330 comporte encore la formation d'un empilement capacitif additionnel par dépôts successifs, au-dessus de la couche de matériau métallique 135b, d'une couche additionnelle de matériau isolant 136b et d'une couche additionnelle de matériau conducteur et notamment métallique 135c. De plus, les couches de matériau métallique 135a et 135b sont déposées ici préférentiellement de manière non conforme.

On raccorde électriquement la couche de matériau métallique 135a et la couche additionnelle de matériau métallique 135c de sorte à former au moins en partie une électrode inférieure de la capacité 600. La couche de matériau métallique 135b sert d'électrode supérieure de la capacité 600. Les trois reprises de contact au niveau du caisson 163 en surface, respectivement C1, C2 et C3, sont indiquées sur la figure 7.

Le caisson 163 joue un rôle primordial puisqu'il permet l'élargissement des électrodes très fines, par exemple 100nm, dans la cavité 165 vers un contact macroscopique (ex: 1µm) permettant son contact électrique. Sans le caisson 163, ledit élargissement ne serait pas possible puisqu'il conduirait à un confinement des couches de l'empilement capacitif et de l'empilement capacitif additionnel elles-mêmes dans la au moins une tranchée 164.

Il semble alors possible d'empiler, un très grand nombre de fois, des empilements capacitifs additionnels dans la au moins une tranchée 164. La reprise de contact se fait alors seulement en bord du caisson 163. En connectant des capacités en parallèle, c'est-à-dire l'ensemble des contacts C1 et C3 par rapport au contact C2, on réalise une très grande capacité qui a de nombreuses applications, telles que la gestion de l'alimentation, le filtrage, et le découplage, etc. En reliant en parallèle au moins deux capacités on peut ainsi augmenter la valeur totale de la capacité formée dans la cavité.

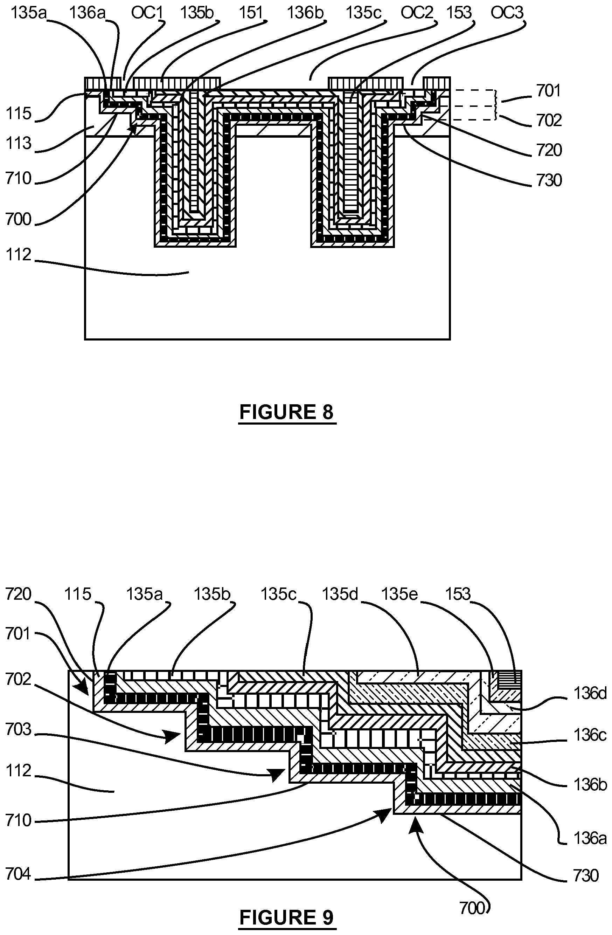

La figure 8 illustre une autre forme de réalisation de l'invention dans laquelle le caisson 163 présente une paroi de flanc 700 s'évasant en direction de l'embouchure de caisson et ayant une composante non nulle suivant l'épaisseur du substrat 112. Dans le cas représenté, la paroi de fond du caisson 163 et la paroi de flanc 700 définissent ensemble le volume intérieur du caisson 163. Dans les cas illustrés aux figures 2 à 7, la paroi de flanc 700 est strictement orientée suivant l'épaisseur du substrat 112. Au contraire, dans le cas de la figure 8, la paroi de flanc 700 n'est pas strictement dirigée suivant cette épaisseur. De cette façon, la paroi de flanc 700 a un profil évasé si bien que sa dimension de base, au niveau de l'embouchure de tranchée est inférieure à sa dimension haute, au niveau de l'embouchure de caisson. Dans la figure 8, le substrat 112 n'est pas utilisé comme électrode inférieure mais on peut appliquer le principe des étages et des empilements capacitifs mentionné précédemment dans ces étages à cette variante de réalisation.

Il faut noter que le profil de la paroi de flanc 700 de la figure 8 est un mode de réalisation représentatif mais non limitatif. D'autres profils configurés pour évaser le caisson 163 en direction de la face du substrat 112 ou se conformant à une volonté d'accueillir un plus grand nombre de couches capacitives sont envisageables sans sortir du cadre de l'invention.

Dans l'exemple de la figure 8, la section transversale du caisson est croissante en s'éloignant de la paroi de fond de caisson. Cette croissance s'opère non limitativement comme dans les figures 8 et 9 par le biais de paliers 710. Chaque palier 710 définit deux étages 701 et 702 de part et d'autre du palier 710 considéré. Les paliers 710 sont avantageusement réalisés par gravure, lors de formation globale du caisson 163. Ils comportent préférentiellement une partie horizontale 730 étendant la section du caisson entre deux étages 701 et 702, en direction de la face du substrat 112. Des parties de flanc 720 assurent les portions montantes du caisson dans cet exemple.

Les étages 701 et 702 sont ainsi délimités par les parties transversales 730 et aussi par des parties verticales 720 (dirigées suivant l'épaisseur du substrat 112) dans le cas illustré où les étages sont en forme de créneaux.

On comprend que sans procéder à des enlèvements de matière trop important en profondeur, cette configuration à paliers ou évasée assure un élargissement important du caisson 163 et la formation d'une embouchure de caisson agrandie.

Cet avantage trouve un intérêt particulier lors de la réalisation d'empilements capacitifs additionnels. En effet, le nombre d'empilements capacitifs est encore moins gêné par l'encombrement des reprises de contact en surface que dans les modes de réalisation des figures 2 à 7.

Pour le cas de la figure 8, un empilement capacitif additionnel a été réalisé comme pour la figure 7, un matériau de remplissage 153 étant par ailleurs opéré en fin de fabrication. Deux étages 701, 702 de caisson sont formés autour d'un palier 710 de sorte à aménager au mieux le volume intérieur du caisson 163 pour recevoir les couches successives des empilements capacitifs.

L'étage 701 est directement en dessous de la face du substrat 112 et a une dimension en profondeur adaptée pour accommoder l'encombrement de l'empilement qui lui correspond. Il en est de même pour l'étage suivant 702. A un étage correspond une suite de couches type premier conducteur (électrode)/isolant/deuxième conducteur (électrode), un conducteur étant commun entre deux suites de couches de deux étages successifs. Plus précisément, on s'arrange avantageusement pour que la profondeur d'un étage soit inférieure à l'épaisseur de sa première électrode ajoutée à l'épaisseur de son isolant, et/ou supérieure à l'épaisseur de l'ensemble de la suite de couches premier conducteur (électrode)/isolant/deuxième conducteur (électrode). Autrement dit, pour un étage n, sa profondeur est de préférence telle que :

« Epaisseur (conducteur n + isolant n) » est inférieure à « profondeur étage n » qui est inférieure ou égale à «Epaisseur (conducteur n + isolant n + conducteur n+1) ».

Ainsi, pour l'étage 701, sa profondeur est choisie selon les épaisseurs des couches de l'empilement capacitif. Pour l'étage suivant 702, la profondeur est choisie en fonction des épaisseurs de l'empilement capacitif additionnel suivant et de l'épaisseur de l'électrode de l'empilement précédent. On entend par précédent que l'empilement considéré a été réalisé par des dépôts immédiatement avant ceux de l'empilement suivant.

Les étages sont donc possiblement de profondeurs différentes suivant les spécificités d'épaisseurs des diverses couches successives des empilements.

On notera que lors de ces dépôts, on s'arrange avantageusement pour qu'ils se conforment au profil de la paroi de flanc 700 de sorte que, à chaque dépôt d'empilement capacitif, un espace résiduel soit préservé pour accueillir l'empilement suivant.

Avant de former des ouvertures de contacts OC1, OC2, OC3, les étapes 350 et 370, comme illustré précédemment, sont ensuite réalisées.

L'étape 350 peut comprendre une planarisation telle qu'un polissage CMP pour enlever les couches de matériau de conducteur 135a, 135b, 135c au niveau de la surface du substrat 112.

L'étape 370 comprend le dépôt d'une couche de passivation 151 diélectrique du type par exemple SiO₂ ou SiN au-dessus des électrodes planarisées 135a, 135b, 135c. Cette étape 370 peut être réalisée par exemple en PECVD (acronyme de l'anglais « Plasma-enhanced chemical vapor deposition »).

L'invention n'est pas limitée aux méthodes de planarisation et n'est pas non plus limitée aux matériaux ni aux méthodes de formation de la couche de passivation 151.

Ensuite, une étape de lithographie et une étape de gravure sont successivement réalisées au niveau de la couche de passivation 151 afin de former les ouvertures de contacts OC1, OC2, OC3.

L'étape de lithographie est réalisée par exemple de manière conventionnelle. Un masque dur est déposé sur la surface supérieure du substrat 112 en dehors des zones destinées à former les ouvertures de contacts OC1, OC2, OC3. L'alignement est rendu possible grâce à la dimension du caisson 700 ; plus précisément, l'alignement est réalisé aisément grâce aux dimensions des étages de caisson 701, 702 et à celles de paliers 710, 720, 730, qui font plusieurs microns de côté.

L'étape de gravure consiste à graver la couche de passivation 151 et ainsi déboucher sur chacune des électrodes 135a, 135b, 135c. Les ouvertures de contacts OC1, OC2, OC3 sont par conséquent formées.

L'étape de formation de contacts d'électrode sera décrite ultérieurement.

L'invention n'est pas limitée aux méthodes de lithographie ni aux méthodes de gravure.

La figure 9 présente une variante de la figure 8 avec une vue partielle d'une capacité dotée d'un caisson en étages 701, 702, 703, 704. Pour quatre étages correspondent quatre électrodes ici réalisées par les couches de matériau conducteur 135 a,b,c,d,e. Le nombre d'étages n'est pas limitatif.

Il est ainsi possible de réaliser des étages multiples emboîtés les uns dans les autres afin de réaliser un empilement multiple de tri-couches du type MIM. Chaque électrode 135a, 135b, 135c, 135d peut être associée un étage, la dernière électrode 135e déposée n'ayant elle pas besoin d'étage.

Avec les conditions précédemment indiquées sur les épaisseurs, il est possible avec une seule étape de CMP de faire apparaître toutes les électrodes d'un seul coup. Le grand avantage réside dans la surface de contact de chaque électrode qui vaut la largeur (dimension transversale) de l'étage associé. Ainsi, même les électrodes fines (dizaine de nm) peuvent être contactées par la face avant grâce à l'épanouissement d'un étage dont la largeur peut être choisie, typiquement supérieur à 1µm. Les photolithographies et gravures multiples des étages sont réalisées facilement par la face, avant dépôt de MIM.

Ce procédé permet d'obtenir n capacités verticales en séries lorsque la reprise de contact se fait indépendamment les unes des autres et/ou en parallèle lorsque tout ou partie de ces capacités sont mises en court circuit.

Les modes de réalisation présentés en référence aux figures 8 et 9 révèlent que la forme du caisson 163 peut être variée et notamment adopter un profil de paroi de flanc différant d'une paroi droite perpendiculaire à la face du substrat 112. Le profil en palier des figures 8 et 9 n'est qu'un exemple de la pluralité de profils possibles pour le caisson 163. D'une manière générale, d'autres profils configurés pour évaser le caisson 163 en direction de la face du substrat 112 sont possibles.

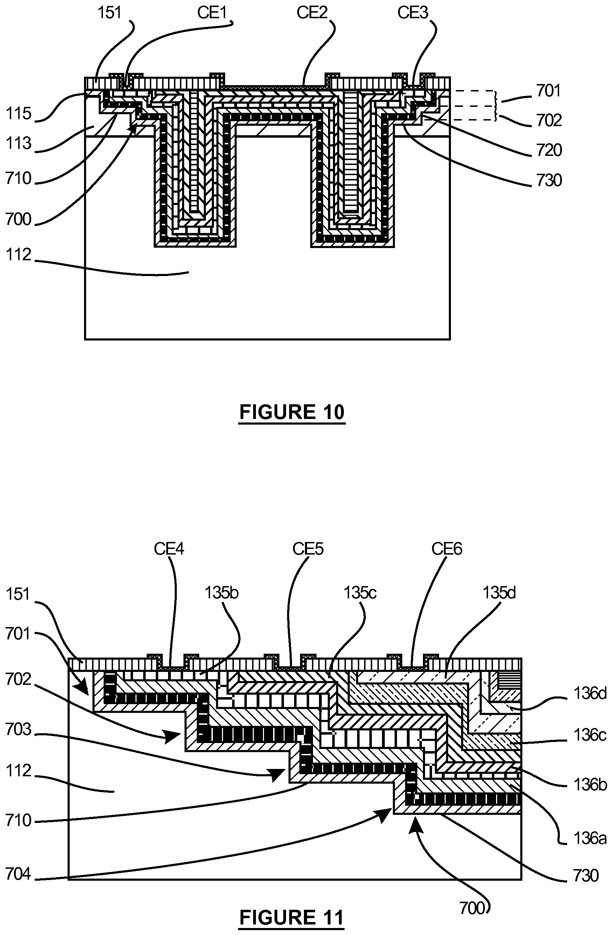

La figure 10 montre le mode de réalisation avec la structure du caisson 700 illustré en figure 8 à l'issue de formation de contacts d'électrode CE1, CE2 et CE3. De même manière, la figure 11 montre le mode de réalisation avec la structure du caisson 700 illustrée en figure 9 à l'issue de la formation de contacts d'électrode CE4, CE5 et CE6.

Prenons le mode de réalisation illustré en figures 8 et 10. A l'issue de la formation des ouvertures de contact OC1, OC2, OC3 décrite précédemment, une couche métallique telle qu'une couche d'aluminium est déposée sur la surface supérieure du substrat 112 ; c'est-à-dire un dépôt d'une couche métallique est réalisé dans les ouvertures de contact OC1, OC2, OC3 et au-dessus de la couche de passivation 151.

Ensuite, une étape de lithographie et une étape de gravure sont successivement réalisées au niveau de ladite couche métallique afin de former les contacts d'électrode CE1, CE2, CE3.

L'étape de lithographie est réalisée par exemple de manière conventionnelle. Un masque dur est déposé sur ladite couche métallique pour recouvrir et ainsi protéger les ouvertures de contacts OC1, OC2, OC3. L'étape de gravure est ensuite réalisée pour enlever, en gardant des portions de la couche métallique recourant les ouvertures de contacts OC1, OC2, OC3, des portions de la couche métallique non recouvertes par le masque dur. Ces portions de la couche métallique laissées sur place sont devenues les contacts d'électrode CE1, CE2, CE3, comme illustré en figure 10.

Il faut noter que les électrodes 135a, 135b, 135c peuvent également être connectées entre elles par ladite couche métallique si on désire mettre les capacités en parallèle directement.

De plus, puisque tout l'empilement capacitif comprenant les couches 135a, 136a, 135b, 136b, 135c est formé dans l'épaisseur du substrat 112 lui-même, il est faisable de réaliser une connexion électrique en formant des contacts d'électrode en face arrière du substrat 112 (celle opposée à la face supérieure du substrat 112) après amincissement ou formation d'un accès électrique pour venir contacter l'électrode inférieure de la capacité.

L'invention permet par conséquent une reprise de contact des électrodes par la face supérieure (éventuellement en association avec des reprises par la face arrière) de toutes les couches de matériau conducteur 135 a,b,c (ou 135 a,b,c,d,e) comme décrit dans les modes de réalisation ci-dessus. On réalise ainsi une capacité totale plus importante étant développée non seulement verticalement mais aussi horizontalement, ce qui est un avantage significatif de l'invention.

L'invention n'est pas limitée aux modes de réalisation précédemment décrits mais s'étend à tout mode de réalisation conforme à ses revendications associées.

## Revendications

1. Procédé pour la réalisation d'une capacité, comprenant une formation d'un empilement capacitif dans une portion d'un substrat (112), le procédé comportant : la formation d'une cavité (165) suivant l'épaisseur de la portion du substrat (112) à partir d'une face supérieure dudit substrat (112), le dépôt d'une pluralité de couches participant à l'empilement capacitif sur la paroi de la cavité (165) et sur la surface de la face supérieure et un enlèvement de la matière des couches jusqu'à la surface de la face supérieure, procédé dans lequel la formation de la cavité (165) comporte la formation d'au moins une tranchée (164) et, associé à chaque tranchée (164), d'au moins un caisson (163), ladite au moins une tranchée (164) comportant une embouchure de tranchée débouchant dans le caisson (163), ledit caisson (163) comportant une embouchure de caisson débouchant au niveau de la surface de la face supérieure, l'embouchure de caisson étant formée plus grande que l'embouchure de tranchée,
**caractérisé en ce que** :
- la formation du caisson (163) comprend la formation d'une paroi de flanc de caisson s'évasant en direction de l'embouchure de caisson;
- il comprend la formation d'au moins un empilement capacitif additionnel par dépôts successifs, au-dessus d'une couche de matériau conducteur (135b, 172) dudit empilement capacitif configurée pour former au moins en partie une électrode supérieure de l'empilement capacitif, d'une couche additionnelle de matériau isolant (136b) et d'une couche additionnelle de matériau conducteur (135c).

2. Procédé selon la revendication 1 dans lequel la formation de l'empilement capacitif et la formation d'au moins un empilement capacitif additionnel sont configurées pour que les couches desdits empilements ne dépassent pas le niveau de la face supérieure du substrat (112).

3. Procédé selon l'une des revendications précédentes, dans lequel ladite pluralité de couches comporte successivement, au-dessus de la paroi de la cavité (165), une première couche de matériau conducteur (135a) configurée pour former au moins en partie une électrode inférieure de la capacité, une deuxième couche de matériau isolant (136a) et une deuxième couche de matériau conducteur (135b) qui forme au moins en partie une électrode supérieure de la capacité.

4. Procédé selon la revendication précédente, comportant une gravure partielle d'une couche de matériau conducteur (135a, 135b) configurée pour que la couche de matériau conducteur (135a, 135b) s'arrête à un niveau inférieur à celui de la deuxième couche de matériau isolant (136a) suivant l'épaisseur du substrat (112).

5. Procédé selon l'une des deux revendications précédentes, dans lequel ladite pluralité de couches comporte une couche de matériau isolant (115) située au-dessus de la paroi de la cavité (165) et au-dessous de la première couche de matériau conducteur (135a).

6. Procédé selon l'une des revendications 1 à 5, comprenant l'utilisation de la portion du substrat (112) comme électrode inférieure de la capacité et dans lequel le dépôt de ladite pluralité de couches comporte successivement au-dessus de la paroi de la cavité (165), le dépôt d'une couche de matériau isolant (171) et d'une couche de matériau conducteur (172) qui forme au moins en partie une électrode supérieure de l'empilement capacitif.

7. Procédé selon la revendication précédente, comportant une gravure partielle de la couche de matériau conducteur (172) configurée pour que la couche de matériau conducteur (172) s'arrête à un niveau inférieur à celui de la deuxième couche de matériau isolant (136a) suivant l'épaisseur du substrat (112).

8. Procédé selon l'une des revendications précédentes dans lequel la formation d'une paroi de flanc de caisson s'évasant comprend la formation, sur la paroi de flanc de caisson s'évasant, d'au moins un palier (710) à un niveau intermédiaire entre l'embouchure de tranchée et l'embouchure de caisson suivant l'épaisseur de la portion de substrat (112), le au moins un palier (710) étant configuré pour définir deux étages de caisson (701, 702).

9. Procédé selon la revendication précédente dans lequel les dépôts successifs du au moins un empilement capacitif additionnel sont configurés pour préserver un espace résiduel dans la cavité (165), espace délimité par ledit empilement additionnel.

10. Procédé selon la revendication précédente dans lequel on forme autant d'étages de caisson que d'empilements capacitifs.

11. Procédé selon la revendication précédente dans lequel on forme un premier empilement capacitif additionnel au-dessus de la couche de matériau conducteur (135b) configurée pour former au moins en partie une électrode supérieure de la capacité, et dans lequel la profondeur de l'étage situé directement sous l'embouchure de caisson suivant l'épaisseur de la portion de substrat (112) est choisie :
- supérieure à la somme des épaisseurs de l'électrode inférieure de la capacité et de la deuxième couche de matériau isolant (136a);
- inférieure ou égale à l'épaisseur de l'empilement capacitif ;
et dans lequel la profondeur de l'étage situé directement en dessous de l'étage situé directement sous l'embouchure de caisson suivant l'épaisseur de la portion de substrat (112) est choisie :
- supérieure à la somme des épaisseurs de l'électrode supérieure de la capacité et de la couche additionnelle de matériau isolant (136b) du premier empilement capacitif additionnel;
- inférieure ou égale à la somme des épaisseurs dudit premier empilement capacitif additionnel et de l'électrode supérieure de la capacité.

12. Procédé selon la revendication précédente, dans lequel, pour tout deuxième empilement capacitif additionnel formé au-dessus du premier empilement capacitif additionnel, on forme un étage supplémentaire situé à un niveau de profondeur supérieur relativement à l'étage correspondant à un empilement capacitif précédent, la profondeur de l'étage supplémentaire étant choisie :
- supérieure à la somme des épaisseurs de la couche additionnelle de matériau conducteur (135c) de l'empilement capacitif additionnel précédent et de la couche additionnelle de matériau isolant (136c) dudit deuxième empilement capacitif additionnel;
- inférieure ou égale à la somme des épaisseurs dudit deuxième empilement capacitif additionnel et de la couche additionnelle de matériau conducteur (135c) dudit empilement capacitif additionnel précédent.

13. Procédé selon l'une des revendications précédentes, dans lequel le dépôt de la pluralité de couches comprend le dépôt non conforme d'au moins une couche.

14. Procédé selon la revendication précédente dans lequel le dépôt non conforme est configuré pour que l'épaisseur de dépôt de ladite au moins une couche soit plus grande dans le caisson (163) suivant une direction transversale à l'épaisseur du substrat (112) que celle de dépôt de ladite au moins une couche dans la tranchée (164).

15. Procédé selon la revendication précédente, dans lequel la réalisation de enlèvement de la matière des couches de l'empilement comprend aussi l'enlèvement de la matière des couches du au moins un empilement additionnel jusqu'à la surface de la face supérieure du substrat (112).

16. Procédé selon l'une des revendications précédentes, dans lequel la portion du substrat (112) est formée pour partie avec une couche superficielle de substrat (113) déposée sur une couche inférieure (112a) du substrat (112) avant la formation de ladite cavité (165), et dans lequel la profondeur du caisson (163) suivant l'épaisseur du substrat (112) est inférieure à l'épaisseur de ladite couche superficielle (113).

17. Dispositif microélectronique comportant un substrat (112) dans une portion (113) duquel s'étend une cavité (165) suivant l'épaisseur du substrat (112) depuis une face supérieure du substrat (112), le dispositif comportant un empilement capacitif et au moins un empilement capacitif additionnel, ledit empilement capacitif constituant au moins en partie une capacité et comportant une pluralité de couches sur la paroi de la cavité (165), la cavité (165) comportant au moins une tranchée (164) et associé à chaque tranchée au moins un caisson (163), ladite au moins une tranchée (164) comportant une embouchure de tranchée débouchant dans le caisson (163), ledit caisson (163) comportant une embouchure de caisson débouchant au niveau de la surface de la face supérieure, l'embouchure de caisson étant plus grande que l'embouchure de tranchée, le caisson (163) comprenant une paroi de flanc de caisson s'évasant en direction de l'embouchure de caisson, ledit empilement capacitif additionnel comprenant une couche additionnelle de matériau isolant (136b) et une couche additionnelle de matériau conducteur (135c) successivement déposées au-dessus d'une couche de matériau conducteur (135b, 172) dudit empilement capacitif.

## Patentansprüche

1. Verfahren zum Herstellen einer Kapazität, umfassend das Ausbilden einer kapazitiven Stapelung in einem Abschnitt eines Substrats (112), wobei das Verfahren umfasst:
Ausbilden eines Hohlraums (165) in der Materialstärke des Abschnitts des Substrats (112) ausgehend von einer Oberseite des Substrats (112), Aufbringen einer Mehrzahl von Schichten, die zu der kapazitiven Stapelung beitragen, auf die Wand des Hohlraums (165) und auf die Oberfläche der Oberseite, und Entfernen von Material von den Schichten bis zur Oberfläche der Oberseite, Verfahren bei dem das Ausbilden des Hohlraums (165) das Bilden von zumindest einem Graben (164) und, jedem Graben (164) zugeordnet, von zumindest einem Kasten (163) umfasst, wobei der zumindest eine Graben (164) eine Grabenmündung enthält, die in den Kasten (163) mündet, wobei der Kasten (163) eine Kastenmündung enthält, die im Bereich der Oberfläche der Oberseite ausmündet, wobei die Kastenmündung größer ausgebildet ist als die Grabenmündung,
**dadurch gekennzeichnet, dass**
- das Ausbilden des Kastens (163) das Ausbilden einer Kastenflankenwand umfasst, die sich in Richtung der Kastenmündung erweitert;
- es das Ausbilden zumindest einer zusätzlichen kapazitiven Stapelung durch aufeinanderfolgendes Aufbringen von einer zusätzlichen Schicht aus Isoliermaterial (136b) und einer zusätzlichen Schicht aus Leitermaterial (135c) über eine Schicht aus Leitermaterial (135b, 172) der kapazitiven Stapelung, die dazu ausgelegt ist, zumindest teilweise eine obere Elektrode der kapazitiven Stapelung zu bilden.

2. Verfahren nach Anspruch 1, wobei das Ausbilden der kapazitiven Stapelung und das Ausbilden der zumindest einen zusätzlichen kapazitiven Stapelung dazu ausgelegt sind, dass die Schichten der Stapelungen nicht die Höhe der Oberseite des Substrats (112) übersteigen.

3. Verfahren nach einem der vorangehenden Ansprüche, wobei die Mehrzahl von Schichten aufeinanderfolgend über der Wand des Hohlraums (165) eine erste Schicht aus Leitermaterial (135a), die dazu ausgelegt ist, zumindest teilweise eine untere Elektrode der Kapazität zu bilden, eine zweite Schicht aus Isoliermaterial (136a) und eine zweite Schicht aus Leitermaterial (135b) enthält, die zumindest teilweise eine obere Elektrode der Kapazität bildet.

4. Verfahren nach dem vorangehenden Anspruch, umfassend ein teilweises Ätzen einer Schicht aus Leitermaterial (135a, 135b), die dazu ausgelegt ist, dass die Schicht aus Leitermaterial (135a, 135b) in einer geringeren Höhe als die zweite Schicht aus Isoliermaterial (136a) in der Materialstärke des Substrats (112) endet.

5. Verfahren nach einem der beiden vorangehenden Ansprüche, wobei die Mehrzahl von Schichten eine Schicht aus Isoliermaterial (115) aufweist, die über der Wand des Hohlraums (165) und unter der ersten Schicht aus Leitermaterial (135a) liegt.

6. Verfahren nach einem der Ansprüche 1 bis 5, umfassend das Verwenden des Abschnitts des Substrats (112) als untere Elektrode der Kapazität, wobei das Aufbringen der Mehrzahl von Schichten aufeinanderfolgend über der Wand des Hohlraums (165) das Aufbringen einer Schicht aus Isoliermaterial (171) und einer Schicht aus Leitermaterial (172) umfasst, die zumindest teilweise eine obere Elektrode der kapazitiven Stapelung bildet.

7. Verfahren nach dem vorangehenden Anspruch, umfassend ein teilweises Ätzen der Schicht aus Leitermaterial (172), das so ausgelegt ist, dass die Schicht aus Leitermaterial (172) in einer geringeren Höhe als die zweite Schicht aus Isoliermaterial (136a) in der Materialstärke des Substrats (112) endet.

8. Verfahren nach einem der vorangehenden Ansprüche, wobei das Ausbilden einer sich erweiternden Kastenflankenwand das Ausbilden zumindest eines Lagers (710) an der sich erweiternden Kastenflankenwand in einer Zwischenhöhe zwischen der Grabenmündung und der Kastenmündung in der Materialstärke des Abschnitts des Substrats (112) umfasst, wobei das zumindest eine Lager (710) dazu ausgelegt ist, zwei Kastenstufen (701, 702) zu definieren.

9. Verfahren nach dem vorangehenden Anspruch, wobei die aufeinanderfolgenden Vorgänge zum Aufbringen der zumindest einen zusätzlichen kapazitiven Stapelung dazu ausgelegt sind, einen restlichen Raum in dem Hohlraum (165) freizulassen, welcher restliche Raum von der zusätzlichen Stapelung begrenzt wird.

10. Verfahren nach dem vorangehenden Anspruch, wobei ebenso viele Kastenstufen ausgebildet werden wie kapazitive Stapelungen.

11. Verfahren nach dem vorangehenden Anspruch, wobei eine erste zusätzliche kapazitive Stapelung über der Schicht aus Leitermaterial (135b) ausgebildet wird, die dazu ausgelegt ist, zumindest teilweise eine obere Elektrode der Kapazität zu bilden, und wobei die Tiefe der unmittelbar unter der Kastenmündung in der Materialstärke liegende Stufe des Substratabschnitts (112) so gewählt ist, dass sie
- größer als die Summe der Materialstärken der unteren Elektrode der Kapazität und der zweiten Schicht aus Isoliermaterial (136a) ist;
- geringer oder gleich der Materialstärke der kapazitiven Stapelung ist;
und wobei die Tiefe der Stufe, die unmittelbar unterhalb der Stufe liegt, die unmittelbar unter der Kastenmündung in der Materialstärke des Substratabschnitts (112) liegt, so gewählt ist, dass sie
- größer als die Summe der Materialstärken der oberen Elektrode der Kapazität und der zusätzlichen Schicht aus Isoliermaterial (136b) der ersten zusätzlichen kapazitiven Stapelung ist;
- geringer oder gleich der Summe der Materialstärken der ersten zusätzlichen kapazitiven Stapelung und der oberen Elektrode der Kapazität ist.

12. Verfahren nach dem vorangehenden Anspruch, wobei für die gesamte zweite zusätzliche kapazitive Stapelung, die über der ersten zusätzlichen kapazitiven Stapelung ausgebildet ist, eine zusätzliche Stufe ausgebildet wird, die in einem Tiefenbereich liegt, der höher als der der Stufe liegt, die einer vorangehenden kapazitiven Stapelung entspricht, wobei die Tiefe der zusätzlichen Stufe so gewählt ist, dass sie
- größer als die Summe der Materialstärken der zusätzlichen Schicht aus Leitermaterial (135c) der vorangehenden zusätzlichen kapazitiven Stapelung und der zusätzlichen Schicht aus Isoliermaterial (136c) der zweiten zusätzlichen kapazitiven Stapelung ist;
- geringer oder gleich der Summe der Materialstärken der zweiten zusätzlichen kapazitiven Stapelung und der zusätzlichen Schicht aus Leitermaterial (135c) der vorangehenden zusätzlichen kapazitiven Stapelung ist.

13. Verfahren nach einem der vorangehenden Ansprüche, wobei das Aufbringen der Mehrzahl von Schichten das nicht konforme Aufbringen zumindest einer Schicht umfasst.

14. Verfahren nach dem vorangehenden Anspruch, wobei das nicht konforme Aufbringen dazu ausgelegt ist, dass die Materialstärke beim Aufbringen der zumindest einen Schicht in dem Kasten (163) in einer Richtung quer zur Materialstärke des Substrats (112) größer ist als die beim Aufbringen der zumindest einen Schicht in dem Graben (164).

15. Verfahren nach dem vorangehenden Anspruch, wobei das Durchführen des Entfernens von Material von den Schichten der Stapelung auch das Entfernen von Material von den Schichten der zumindest einen zusätzlichen Stapelung bis zu der Oberfläche der Oberseite des Substrats (112) umfasst.

16. Verfahren nach einem der vorangehenden Ansprüche, wobei der Abschnitt des Substrats (112) zum Teil mit einer Substratoberflächenschicht (113) ausgebildet ist, die auf eine untere Schicht (112a) des Substrats (112) vor der Ausbildung des Hohlraums (165) aufgebracht wird, und wobei die Tiefe des Kastens (163) in der Materialstärke des Substrats (112) geringer als die Materialstärke der Oberflächenschicht (113) ist.

17. Mikroelektronische Vorrichtung mit einem Substrat (112) in einem Abschnitt (113), von dem sich ein Hohlraum (165) in der Materialstärke des Substrats (112) von einer Oberseite des Substrats (112) aus erstreckt, wobei die Vorrichtung eine kapazitive Stapelung und zumindest eine zusätzliche kapazitive Stapelung enthält, wobei die kapazitive Stapelung zumindest teilweise eine Kapazität darstellt und eine Mehrzahl von Schichten an der Wand des Hohlraums (165) enthält, wobei der Hohlraum (165) zumindest einen Graben (164) und, jedem Graben zugeordnet, zumindest einen Kasten (163) aufweist, wobei zumindest ein Graben (164) eine Grabenmündung enthält, die in den Kasten (163) mündet, wobei der Kasten (163) eine Kastenmündung enthält, die im Bereich der Oberfläche der Oberseite ausmündet, wobei die Kastenmündung größer ausgebildet ist als die Grabenmündung, wobei der Kasten (163) eine Kastenflankenwand umfasst, die sich in Richtung der Kastenmündung erweitert, wobei die zusätzliche kapazitive Stapelung eine zusätzliche Schicht aus Isoliermaterial (136b) und eine zusätzliche Schicht aus Leitermaterial (135c) enthält, die aufeinanderfolgend über eine Schicht aus Leitermaterial (135b, 172) der kapazitiven Stapelung aufgebracht sind.

## Claims

1. A method for producing a capacitor, comprising the forming of a capacitor stack in one portion of a substrate (112), with the method comprising: the forming of a cavity (165) along the thickness of the portion of the substrate (112) from an upper surface of said substrate (112), the depositing of a plurality of layers contributing to the capacitor stack onto the wall of the cavity (165) and onto the surface of the upper face and the removing of matter from the layers until the surface of the upper face is reached, a method wherein the forming of the cavity (165) comprises the forming of at least one trench (164) and, associated with each trench (164), of at least one box (163), with said at least one trench (164) comprising a trench outlet that opens into the box (163), with said box (163) comprising a box outlet that opens at the surface of the upper face, and the box outlet being shaped so as to be larger than the trench outlet, **characterized in that**:
- the forming of the box (163) comprises the forming of a box side wall flaring towards the box outlet;
- it comprises the forming of at least one additional capacitor stack by successive depositions, above a layer of conductive material (135b, 172) of said capacitive stack so configured as to form at least a part of the upper electrode of the capacitive stack, an additional layer of insulating material (136b) and an additional layer of conductive material (135c).

2. A method according to claim 1, wherein the forming of the capacitor stack and the forming of at least one additional capacitor stack are so configured as the layers of said stacks do not exceed the level of the upper face surface of the substrate.

3. A method according to one of the preceding claims, wherein said plurality of layers comprises successively, above the wall of the cavity (165), a first layer of conductive material (135a) so configured as to form at least a part of a bottom electrode of the capacitor, a second layer of insulating material (136a) and a second layer of conductive material (135b) which at least partly forms an upper electrode of the capacitor.

4. A method according to the preceding claim, comprising etching partially a layer of conductive material (135a, 135b) so configured that the layer of conductive material (135a, 135b) stops at a lower level than that of the second layer of insulating material (136a) along the thickness of the substrate (112).

5. A method according to one of the two preceding claims, wherein said plurality of layers comprises a layer of insulating material (115) located above the wall of the cavity (165) and under the first layer of conductive material (135a).

6. A method according to one of claims 1 to 5, comprising using the portion of the substrate (112) as the lower electrode of the capacitor and wherein the deposition of said plurality of layers comprises successively above the wall of the cavity (165), depositing a layer of insulating material (171) and a layer of conductive material (172) which forms at least in part an upper electrode of the capacitor stack.

7. A method according to the preceding claim, comprising etching partially a layer of conductive material (172) so configured that the layer of conductive material (172) stops at a lower level than that of the second layer of insulating material (136a) along the thickness of the substrate (112).

8. A method according to one of the preceding claims, wherein the forming of a flared box side wall comprises the forming, on the flared box side wall, of at least one landing (710) at an intermediate level between the trench outlet and the box outlet along the thickness of the portion of the substrate (112), with the at least one landing (710) being so configured as to define two box stages (701, 702).

9. A method according to the preceding claim, wherein the successive depositions of the at least one additional capacitor stack is so configured as to preserve a residual space in the cavity (165), space defined by said additional stack.

10. A method according to the preceding claim, wherein as many box stages as capacitor stacks are formed.

11. A method according to the preceding claim, wherein a first additional capacitor stack is formed above the layer of conductive material (135b) so configured as to form at least in part an upper electrode of the capacitor, and wherein the depth of the stage located directly under the outlet of the box along the thickness of the portion of the substrate (112) is so selected as to be:
- greater than the sum of the thicknesses of the lower electrode of the capacitor and of the second layer of insulating material (136a);
- smaller than or equal to the thickness of the capacitor stack,
and wherein the depth of the stage located directly under the stage located directly below the outlet of the box along the thickness of the portion of the substrate (112) is so selected as to be:
- greater than the sum of the thicknesses of the upper electrode of the capacitor and the additional layer of insulating material (136b) of the first additional capacitor stack;
- smaller than or equal to the sum of the thicknesses of said first additional capacitor stack and the upper electrode of the capacitor.

12. A method according to the preceding claim, wherein, for all second additional capacitor stack formed over the first additional capacitor stack, an additional stage is formed at a higher depth level relative than the upper stage corresponding to a previous capacitive stack, with the depth of the additional stage being so selected as to be:
- greater than the sum of the thicknesses of the additional layer of conductive material (135c) of the previous additional capacitive stack and the additional layer of insulating material (136c) of said second additional capacitor stack;
- smaller than or equal to the sum of the thicknesses of said second additional capacitor stack and the additional layer of conductive material (135c) of said previous additional capacitive stack.

13. A method according to one of the preceding claims, wherein the deposition of the plurality of layers comprises the non-conforming deposition of at least one layer.

14. A method according to the preceding claim, wherein the non-conforming deposition is so configured that the deposition thickness of said at least one layer is greater in the box (163) in a direction transverse to the thickness of the substrate (112) than that of the deposition of said at least one layer in the trench (164).

15. A method according to the preceding claim, wherein the removing of matter from the layers of the stack also comprises the removing of matter from the layers of at least one additional stack until the surface of the upper face of the substrate (112) is reached.

16. A method according to one of the preceding claims, wherein the portion of the substrate (112) is formed in part with a surface layer (113) of the substrate deposited on a bottom layer (112a) of the substrate (112) prior to the forming of said cavity (165), and wherein the depth of the box (163) along the thickness of the substrate (112) is smaller than the thickness of said surface layer (113).

17. A microelectronic device comprising a substrate (112) in a portion (113) of which a cavity (165) extends along the thickness of the substrate (112) from an upper face of the substrate (112), with the device comprising a capacitor stack and at least one additional capacitor stack, with said capacitive stack constituting at least partially a capacitor and comprising a plurality of layers on the wall of the cavity (165), with the cavity (165) comprising at least one trench (164) and at least one box (163) associated with each trench, with said at least one trench (164) comprising a trench outlet that opens into the box (163), with said box (163) comprising a box outlet that opens at the surface of the upper face, with the box outlet being larger than the trench outlet, the box (163) comprising a box side wall flaring towards the box outlet, with said additional capacitive stack comprising an additional layer of insulating material (136b) and an additional layer of conductive material (135c) deposited successively above a conductive material layer (135b, 172) of said capacitor stack.
